# EUROPEAN PATENT SPECIFICATION

(11) **EP 4 403 330 B1**
(45) Date of publication and mention of the grant of the patent: **01.04.2026**
(21) Application number: 22869658.9
(22) Date of filing: 22.06.2022
(51) Int. Cl.: B29C 31/02, B29C 31/04, B29C 45/18, B29C 45/02, B29C 45/14, B29C 45/76, H01L 21/56

(54) **RESIN SUPPLY APPARATUS, RESIN MOLDING SYSTEM, AND METHOD FOR PRODUCING RESIN MOLDED PRODUCT**
HARZZUFÜHRVORRICHTUNG, HARZFORMSYSTEM UND VERFAHREN ZUR HERSTELLUNG EINES HARZFORMPRODUKTS
APPAREIL D'ALIMENTATION EN RÉSINE, SYSTÈME DE MOULAGE DE RÉSINE ET MÉTHODE DE PRODUCTION D'UN PRODUIT MOULÉ EN RÉSINE

(30) Priority: 15.09.2021 JP 2021150276
(43) Date of publication of application: 24.07.2024
(73) Proprietor: Towa Corporation, Kyoto-shi, Kyoto 601-8105 (JP)
(72) Inventor: YOSHIDA Shuhei, Kyoto-shi, Kyoto 601-8105 (JP)
(74) Representative: Winter, Brandl - Partnerschaft mbB
(86) International application number: PCT/JP2022/024802
(87) International publication number: WO 2023/042509

(56) References cited:
- JP-A- 2012 121 243
- JP-A- H08 504 697
- JP-A- H10 113 929
- JP-U- 3 132 439
- US-A1- 2001 033 876

## Description

### Technical Field

This disclosure relates to a resin supply apparatus, a resin molding system, and a method for producing a resin molded product.

### Background Art

Patent Literature 1 discloses an apparatus including a supply feed device, a cutting and selecting device, and a braking device. The supply feed device continuously conveys pellets to the cutting and selecting device, which then removes imperfectly cylindrical pellets and pellet fragments to convey only sorted pellets to the braking device through a hose. The apparatus disclosed in Patent Literature 1 also includes a pellet separating device, a conveying device, and a molding device. The pellet separating device includes a buffer for receiving pellets conveyed at relatively high speeds and then slowed by the braking device. The conveying device conveys the pellets to the molding device, which then molds lead frames with chips mounted thereon with resin ("capsulation" in Patent Literature 1).

The apparatus disclosed in Patent Literature 1 is configured to adjust the amount of pellets to be conveyed to the molding device for molding lead frames with resin and eventually supply pellets to a die ("template" in Patent Literature 1).

Document JP 2012 121243 A discloses a resin supply apparatus according to the preamble of claim 1.

### Citation List

### Patent Literature

**Patent Literature 1**
Japanese Translation of PCT International Application, JP H8-504697 A

### Summary

### Technical Problem

Patent Literature 1 discloses repeating a sealing step of placing lead frames with chips mounted thereon into cavities of the die and sealing up the lead frames with resin. Repeating the step over a long time period requires continuing to supply necessary amounts of pellets (hereinafter also referred to as "tablets").

As disclosed in Patent Literature 1, a resin supply apparatus including only one hopper for storing a resin material needs to, in response to the hopper having used up all the resin material, stop its operation temporarily so that an operator then manually recharges the hopper with the resin material. Further, to switch resin materials for a switch of models of products to be molded, the resin supply apparatus needs to stop its operation temporarily and discharge any remaining resin material so that an operator then manually recharges the hopper with a new resin material. As described above, conventional art has made it difficult to continue operation over a long time period.

The above circumstances have led to a demand for a resin supply apparatus, a resin molding system, and a method for producing a resin molded product each of which makes it possible to continue operation over a long time period.

### Solution to Problem

A resin supply apparatus according to this disclosure characteristically includes: a plurality of resin storages each configured to store a plurality of columnar resin material pieces; a plurality of resin conveying mechanisms corresponding to the respective resin storages and each configured to receive the resin material pieces from a corresponding one of the resin storages, align the resin material pieces, and feed the resin material pieces; a plurality of feed guides corresponding to the respective resin conveying mechanisms and each configured to receive the resin material pieces from a corresponding one of the resin conveying mechanisms and hold the resin material pieces as the resin material pieces are arranged linearly; a shift guide movable between a plurality of receiving positions, at which the shift guide receives the resin material pieces from the respective feed guides, and a discharge position, at which the shift guide discharges the resin material pieces that the shift guide has received; and a moving mechanism facing the discharge position and configured to move the resin material pieces that the shift guide has received to a discharge port.

A resin molding system according to this disclosure characteristically includes: the resin supply apparatus; and a resin molding apparatus configured for resin molding with use of the resin material pieces from the resin supply apparatus.

A method according to this disclosure for producing a resin molded product characteristically includes: supplying the resin material pieces from the resin supply apparatus; and resin molding with use of the resin material pieces supplied from the resin supply apparatus.

### Advantageous Effects

This disclosure provides a resin supply apparatus, a resin molding system, and a method for producing a resin molded product each of which only needs less frequent supply of resin material pieces.

### Brief Description of Drawings

FIG. 1 is a plan view of a tablet stocker, illustrating its configuration.
FIG. 2 is a cross-sectional plan view of a resin molding apparatus.
FIG. 3 is a cross-sectional side view of a hopper, a belt conveyor, and an aligner-feeder.
FIG. 4 is a perspective view of the terminal end of a belt conveyor, illustrating its structure.
FIG. 5 is a plan view of feed guides.
FIG. 6 is a front view of feed guides.
FIG. 7 is a side view of a feed guide.
FIG. 8 is a view of a feed rail as switched in a discard state.
FIG. 9 is a plan view of a shift guide and a pusher, illustrating their arrangement.
FIG. 10 is a view of position sensors, illustrating how the position sensors are positioned.
FIG. 11 is a side view of a shift guide and a pusher, illustrating their arrangement.
FIG. 12 is a view of a relay guide at a relay position and a pusher.
FIG. 13 is a view of a relay guide at a shifted position.

### Description of Embodiments

The description below deals with embodiments of this disclosure with reference to drawings.

### [Basic Configuration]

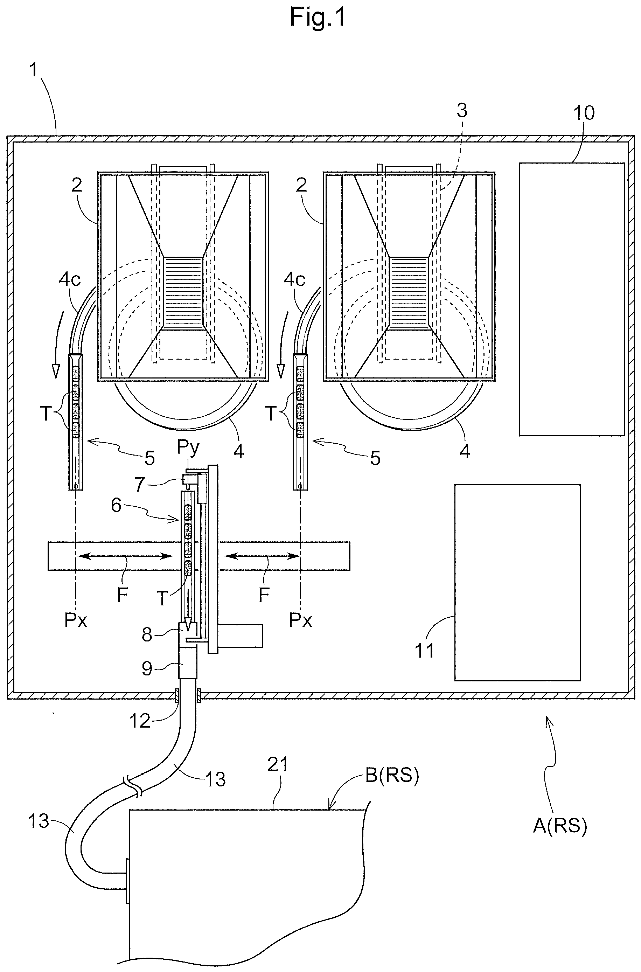

FIG. 1 illustrates a tablet stocker A (which is an example of the "resin supply apparatus") including inside a case 1 two hoppers 2 (which is an example of the "resin storages"), two belt conveyors 3, two aligner-feeders 4 (which is an example of the "resin conveying mechanisms"), two feed guides 5, and a single shift guide 6. The tablet stocker A further includes inside the case 1 a pusher 7 (which is an example of the "moving mechanism"), a relay guide 8, an end guide 9, a control unit 10, and a dust collector 11. The control unit 10 is configured to control how the tablet stocker A operates, and may be outside the case 1.

The two hoppers 2 are each configured to store a large number of cylindrical tablets T (which is an example of the "resin material pieces"). The tablet stocker A is configured to, when causing one of the hoppers 2 to discharge its tablets T, cause the corresponding belt conveyor 3 and aligner-feeder 4 to operate. Through this operation, the aligner-feeder 4 transfers the cylindrical tablets T to the corresponding feed guide 5, which then keeps the tablets T in such a manner that the tablets T are arranged linearly and coaxially.

The shift guide 6 is configured to perform a shifting operation, that is, to reciprocate in a shift direction F orthogonal to the direction in which the feed guides 5 convey tablets T.

The tablet stocker A discharges tablets T as follows: First, the tablet stocker A places the shift guide 6 at a receiving position Px illustrated in FIG. 1. The shift guide 6 then receives from the corresponding feed guide 5 a predetermined number of tablets T aligned with one another. Next, the tablet stocker A moves the shift guide 6 to a discharge position Py. After that, the tablet stocker A causes the pusher 7 to operate so that the pusher 7 causes a predetermined number of tablets T to move past the relay guide 8 and the end guide 9 to be discharged through a discharge port 12 at an end of the end guide 9.

The tablet stocker Ais provided with a conveying path 13 formed by a tube made of a flexible resin and connected to the outer end of the discharge port 12. The tablets T received into the conveying path 13 are supplied to a resin molding apparatus B due to suction force caused by negative pressure. The tablet stocker A discharges tablets T as above under control of the control unit 10. The control unit 10 is capable of, in response to determining that one of the hoppers 2 has discharged all its tablets T, starting to cause the other hopper 2 to discharge its tablets T.

The control unit 10 includes components such as a microprocessor, a digital signal processor (DSP), a memory, and an interface necessary for access to information to control the individual sections of the tablet stocker A with use of preset programs.

The dust collector 11 functions to collect dust and fragments of tablets T at respective lower portions of the hoppers 2 and on the aligner-feeders 4 with use of an airflow. The tablet stocker A includes inside the case 1 ducts (not illustrated in the drawings) connected to the respective lower portions of the hoppers 2 and to the aligner-feeders 4 for the collection. The tablet stocker A also includes inside the case 1 a fan (not illustrated in the drawings) with use of which the dust collector 11 sucks air and a filter (not illustrated in the drawings) configured to remove dust and fragments of tablets T.

The description of the present embodiment uses the term "upstream" to refer to that side in the direction in which the feed guides 5 and the shift guide 6 convey tablets T which is toward the hoppers 2 and the term "downstream" to refer to the opposite side.

### [Resin Molding System and Method for Producing Resin Molded Product]

The description below deals with a resin molding system RS including the tablet stocker A (which is an example of the "resin supply apparatus") and a resin molding apparatus B configured for resin molding with use of tablets T ("resin material pieces") fed by the tablet stocker A.

The description below also deals with a method for producing a resin molded product which method may be expressed as including the tablet stocker A feeding tablets T ("resin material pieces") and the resin molding apparatus B molding resin in the form of the tablets T.

The tablet stocker A is configured to operate under control of the control unit 10 in, for example, either of a continuous feed mode and a selective feed mode both described below. The continuous feed mode is suitable for the case of the resin molding apparatus B producing resin molded products of a single model in a large number. In the continuous feed mode, the tablet stocker A first allows the two hoppers 2 to receive tablets T of a single resin material for storage, and continuously discharges tablets T from one of the hoppers 2 through the discharge port 12 in such a manner that the tablets T are aligned with one another. In response to determining that the hopper 2 has discharged all its tablets T through the above operation, the control unit 10 causes the tablet stocker A to start to discharge tablets T from the other hopper 2 through the discharge port 12 in such a manner that the tablets T are aligned with one another.

The selective feed mode is suitable for the case of the resin molding apparatus B producing resin molded products of two or more models. In the selective feed mode, the tablet stocker A first allows the two hoppers 2 to receive tablets T of respective different resin materials for storage, and discharges tablets T from one of the hoppers 2 through the discharge port 12 in such a manner that the tablets T are aligned with one another. In response to receiving an instruction to switch models of resin molded products to be produced by the resin molding apparatus B or an instruction to switch kinds of tablets T, the control unit 10 causes the tablet stocker A to start to discharge tablets T from the other hopper 2 through the discharge port 12 in such a manner that the tablets T are aligned with one another.

As described above, the control unit 10 is configured to select either the continuous feed mode or the selective feed mode in controlling the tablet stocker A.

### [Basic Configuration of Resin Molding Apparatus]

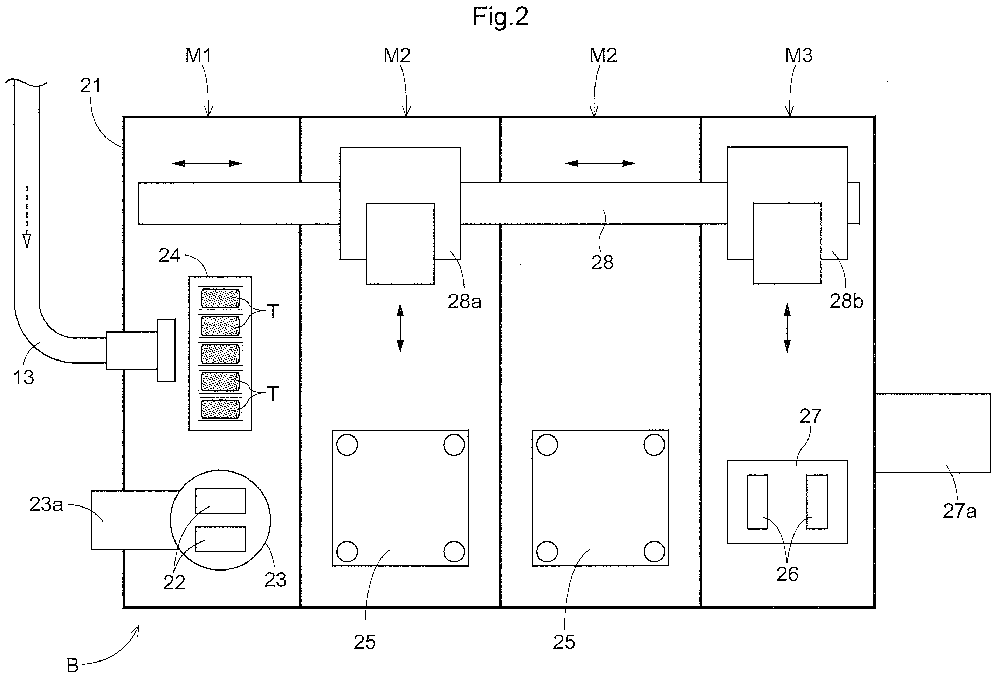

As illustrated in FIG. 2, the resin molding apparatus B includes a module case 21, and also includes inside the module case 21 a single loading module M1, two molding modules M2, and a single unloading module M3. The resin molding apparatus B is in a clean room, whereas the tablet stocker A described above is outside the clean room. If the resin molding apparatus B is in a clean space such as a clean room or clean booth, the tablet stocker A may be in or outside the same clean space. In view of, for example, contamination by tablets T or resulting from an operator supplying resin materials, the tablet stocker A should preferably be outside the clean space in which the resin molding apparatus B is.

The loading module M1 includes a frame placement section 23 and a supply conveyor 23a. The frame placement section 23 is a section on which to temporarily hold lead frames 22 (which is an example support) on which semiconductor chips (which is an example electronic element) are mounted. The supply conveyor 23a is configured to supply lead frames 22 from outside the resin molding apparatus B to the frame placement section 23. The loading module M1 includes a tablet placement section 24 on which to temporarily place tablets T conveyed through the conveying path 13. The support may be, other than a lead frame 22, a substrate such as a printed wiring board or a resin substrate. The electronic element mounted on the support may be, other than a semiconductor chip, an element such as a resistor element or a capacitor element. The lead frames 22 on which semiconductor chips are mounted are an example object to be molded by the resin molding apparatus B.

The two molding modules M2 each include a mold die 25 configured to seal up semiconductor chips with resin.

The unloading module M3 includes a table 27 on which to temporarily hold resin molded products 26 as the lead frames 22 with the semiconductor chips sealed up in resin. The unloading module M3 includes a degating section (not illustrated in the drawings) configured to remove from resin molded products 26 on the table 27 unnecessary resin originating from, for example, culls and runners. The unloading module M3 causes the degating section to remove unnecessary resin from resin molded products 26 and then conveys the resin molded products 26 out of the resin molding apparatus B through a discharge path 27a.

The resin molding apparatus B also includes a supply pickup section 28a, a takeout pickup section 28b, and a linear guide 28. The supply pickup section 28a is configured to convey lead frames 22 that have not been resin molded, whereas the takeout pickup section 28b is configured to convey resin molded products 26. The linear guide 28 extends from the loading module M1 to the unloading module M3, and allows the supply pickup section 28a and the takeout pickup section 28b to move therealong between the loading module M1 and the unloading module M3.

The resin molding apparatus B is configured as follows: The supply pickup section 28a operates to supply lead frames 22 from the frame placement section 23 into one of the mold dies 25 (specifically, between its upper and lower dies) and also supply tablets T from the tablet placement section 24 into pots of the mold die 25. The mold die 25 then heats and melts the tablets T (that is, a resin material) in the pots. A transfer mechanism (not illustrated in the drawings) applies pressure to a plunger (not illustrated in the drawings) to lift the plunger, which pushes the molten resin material out of the pots into cavities in the mold die 25. The resin material in the cavities is thermoset to seal **up** the semiconductor chips. This molding process is called transfer molding.

The above-described configuration of and molding operation by the resin molding apparatus B are a mere example: The resin molding apparatus B is not necessarily configured as illustrated in FIG. 2. The tablet stocker A ("resin supply apparatus") may be for use to feed tablets T to a resin molding apparatus B configured and operable differently.

### [Belt Conveyors and Aligner-feeders]

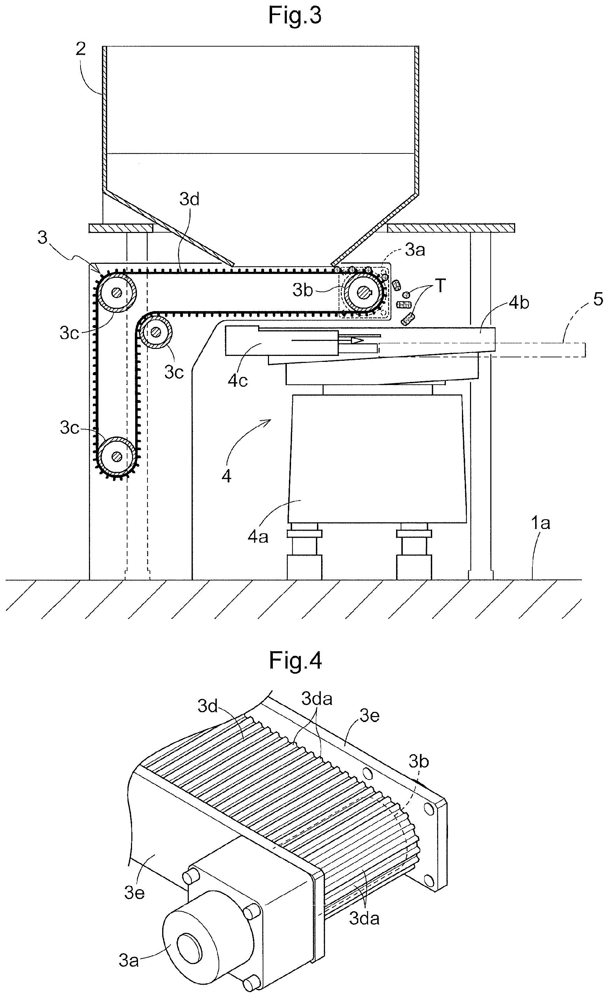

The description below deals with the tablet stocker A in detail. As illustrated in FIGs. 3 and 4, each belt conveyor 3 of the tablet stocker A includes a conveyor motor 3a, a driving pulley 3b drivable by the conveyor motor 3a, driven pulleys 3c, and a conveyor belt 3d movable by the driven pulleys 3c. The belt conveyor 3 is configured to receive tablets T from the corresponding hopper 2, convey the tablets T horizontally, and drop the tablets T at the conveying terminal end into the corresponding aligner-feeder 4.

As illustrated in FIG. 4, the conveyor belt 3d has a surface with linear protrusions 3da arranged at predetermined intervals. The belt conveyor 3 includes a pair of guide plates 3e on respective opposite sides of the conveyor belt 3d.

Each aligner-feeder 4 includes a vibrator 4a, an aligner 4b, and a discharger 4c. The vibrator 4a is disposed under the aligner 4b and configured to vibrate the aligner 4b. The aligner 4b is configured to convey tablets T with use of the vibration transmitted from the vibrator 4a. The aligner 4b includes a guide having a spiral shape in a plan view to align tablets T. The discharger 4c is configured to discharge tablets T aligned by the aligner 4b.

The aligner-feeder 4 is configured to discharge aligned tablets T with use of the discharger 4c onto a portion of the corresponding feed guide 5 which portion is upstream in the direction in which the feed guide 5 conveys tablets T.

### [Feed guides as Configuration for Conveying Tablets]

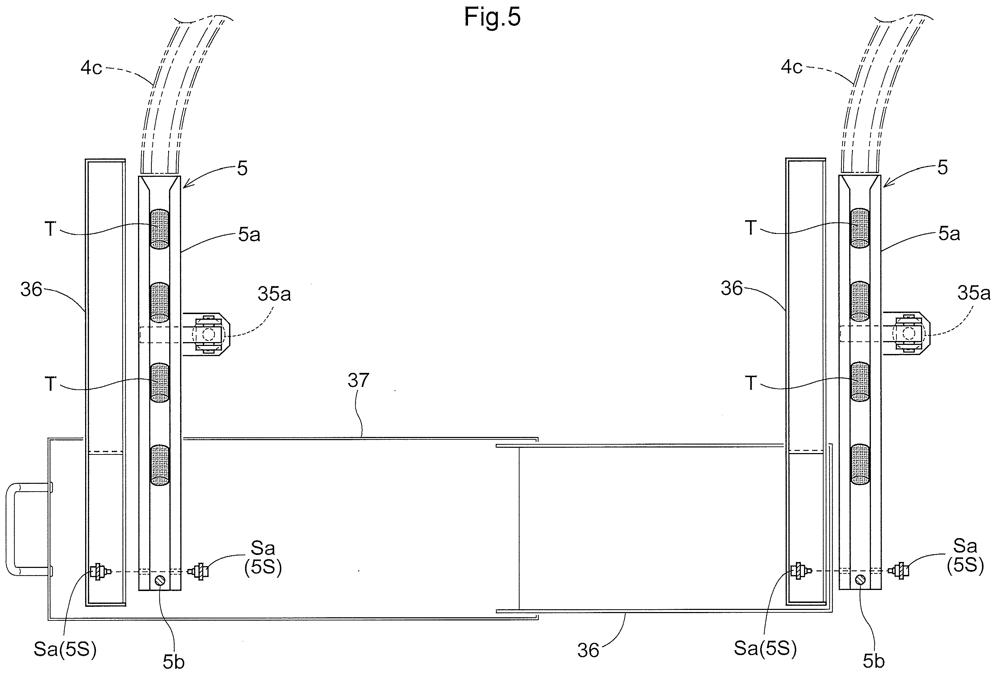

As illustrated in FIGs. 5 to 8, the two feed guides 5 are parallel to each other. Each feed guide 5 includes a feed rail 5a configured to convey tablets T, a downstream stopper 5b (which is an example of the "stopper") at an end downstream in the direction in which the feed guide 5 conveys tablets T, and an arrival sensor 5S configured to detect a tablet T at the downstream end.

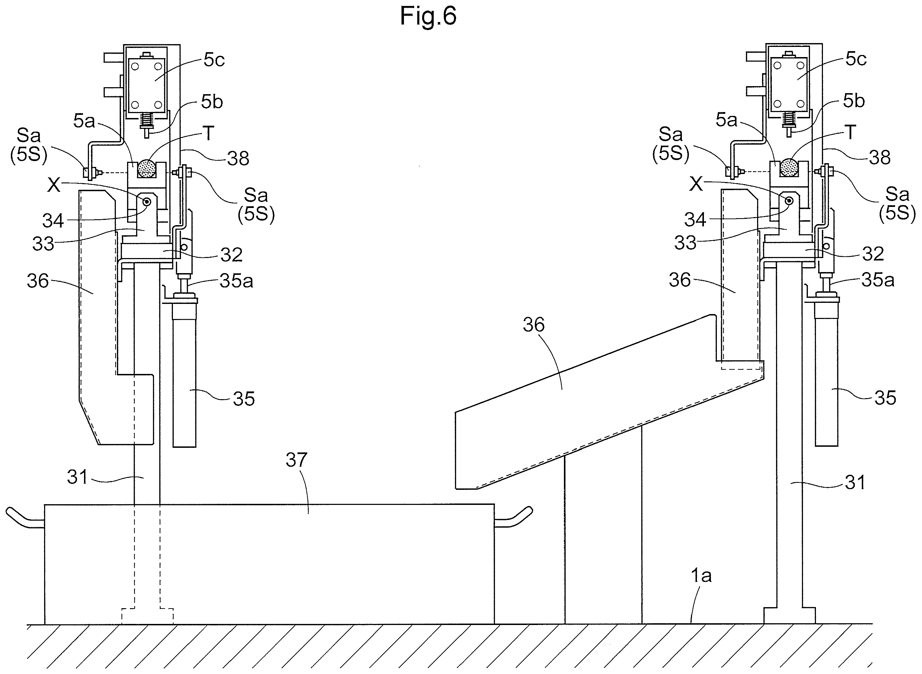

The feed rail 5a is a linear rail having a groove extending along the rail and disposed in the widthwise middle and configured to convey tablets T as aligned. FIGs. 5 and 6 illustrate both the feed rails 5a as holding tablets T to facilitate understanding of where tablets T are held. During the normal operation of feeding tablets T, only one of the two feed rails 5a holds tablets T, as the tablet stocker A continuously conveys tablets T from only one of the two hoppers 2. The state illustrated in FIGs. 5 and 6 may result when one hopper 2 starts to supply a resin material after the other hopper 2.

The tablet stocker A includes supportive columns 31 standing on the bottom wall 1a of the case 1 in correspondence with the two feed guides 5. The tablet stocker A includes frames 32 each extending in the longitudinal direction of the corresponding feed guide 5 and provided with a bracket 33 and a rotary shaft 34. Each feed rail 5a is supported by the corresponding bracket 33 and rotatable about the corresponding rotary shaft 34.

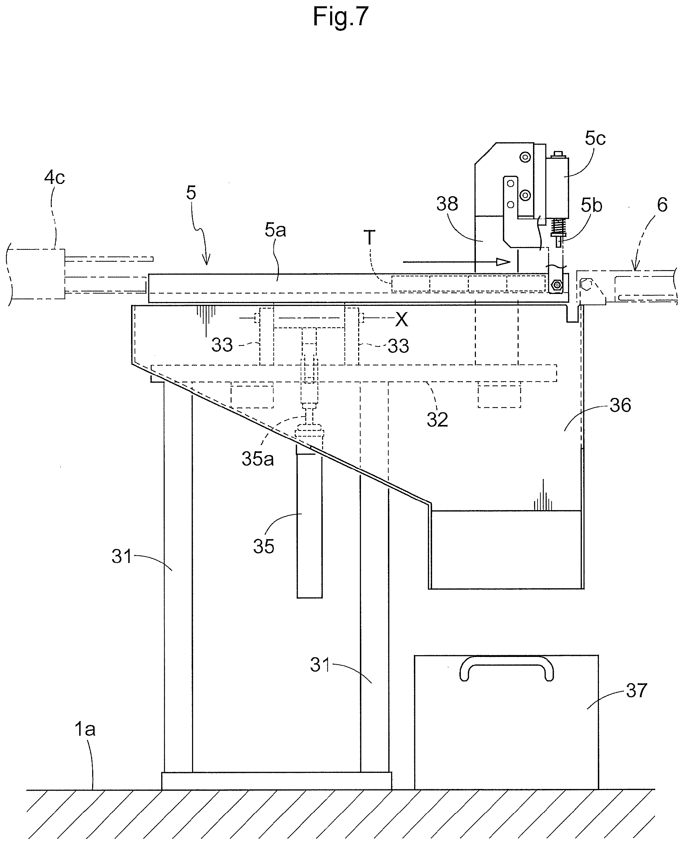

The feed rails 5a each have an area for holding tablets T which area is open on the side (upward in FIGs. 6 and 7) opposite to the gravitational direction. The rotary shafts 34 each extend in the direction in which the corresponding feed guide 5 conveys tablets T, and each coincide with the corresponding rotation axis X. The tablet stocker A includes fluid-pressure rotation cylinders 35 (which is an example of the "actuator") each configured to rotate the corresponding feed rail 5a about the corresponding rotation axis X.

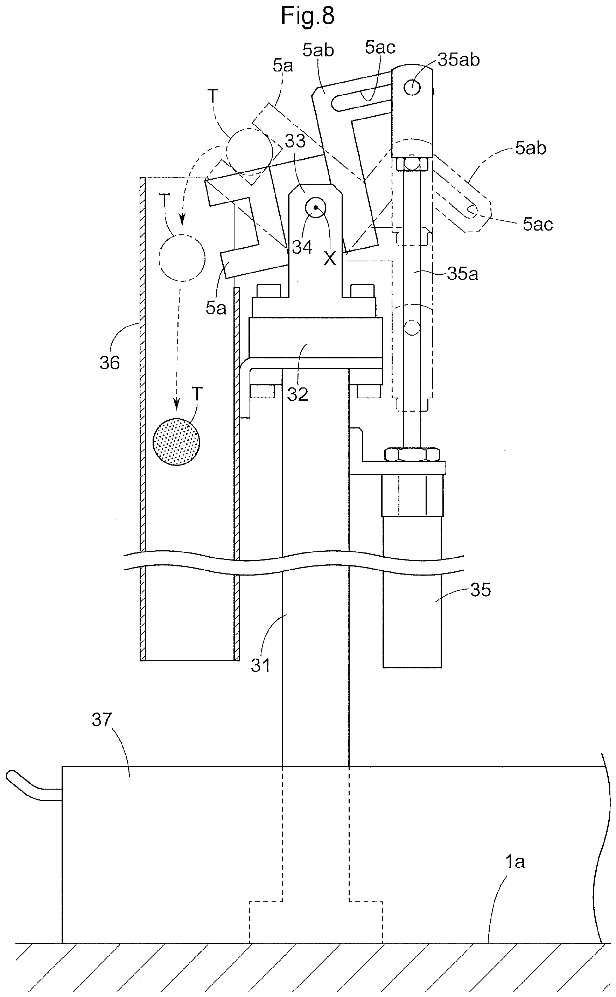

As illustrated in FIG. 8, the feed rails 5a are each coupled to a link member 5ab with a long hole 5ac. The rotation cylinders 35 each include a piston rod 35a with a coupling pin 35ab through the long hole 5ac in the corresponding link member 5ab. The feed rails 5a each remain in a conveying state while the piston rod 35a of the corresponding rotation cylinder 35 is in the pulled state illustrated in FIG. 6. Pushing the piston rod 35a causes the feed rail 5a to rotate about the corresponding rotary shaft 34 into the discard state illustrated in FIG. 8.

Switching the feed rail 5a into the discard state illustrated in FIG. 8 lets each tablet T on the feed rail 5a fall due to its self weight. The tablet stocker A includes front chutes 36 each disposed near the corresponding feed rail 5a and configured to receive tablets T falling as above and guide the tablets T. The tablet stocker A also includes a front collection case 37 disposed on the bottom wall 1a of the case 1 and under the front chutes 36 and configured to collect tablets T from the front chutes 36.

As illustrated in FIGs. 6 and 7, the feed guides 5 each include a switching actuator 5c disposed downstream along the corresponding feed rail 5a and above the feed rail 5a and configured to drive the corresponding downstream stopper 5b. The switching actuator 5c is supported by the corresponding frame 32 with a stay 38 in-between. The downstream stopper 5b is drivable by the switching actuator 5c to switch between a passage preventing position, in which the downstream stopper 5b protrudes downward to prevent tablets T from being discharged, and a passage allowing position, in which the downstream stopper 5b recedes upward to allow tablets T to be discharged.

The arrival sensor 5S includes a pair of elements Sa, namely a light-emitting element and a light-receiving element, each so positioned as to be capable of detecting a tablet T in contact with the downstream stopper 5b. Specifically, the feed rail 5a has a through hole, through which the light-emitting element emits a light beam to be received by the light-receiving element. The arrival sensor 5S detects a tablet T in response to the light beam being blocked.

### [Shift guide as Configuration for Conveying Tablets]

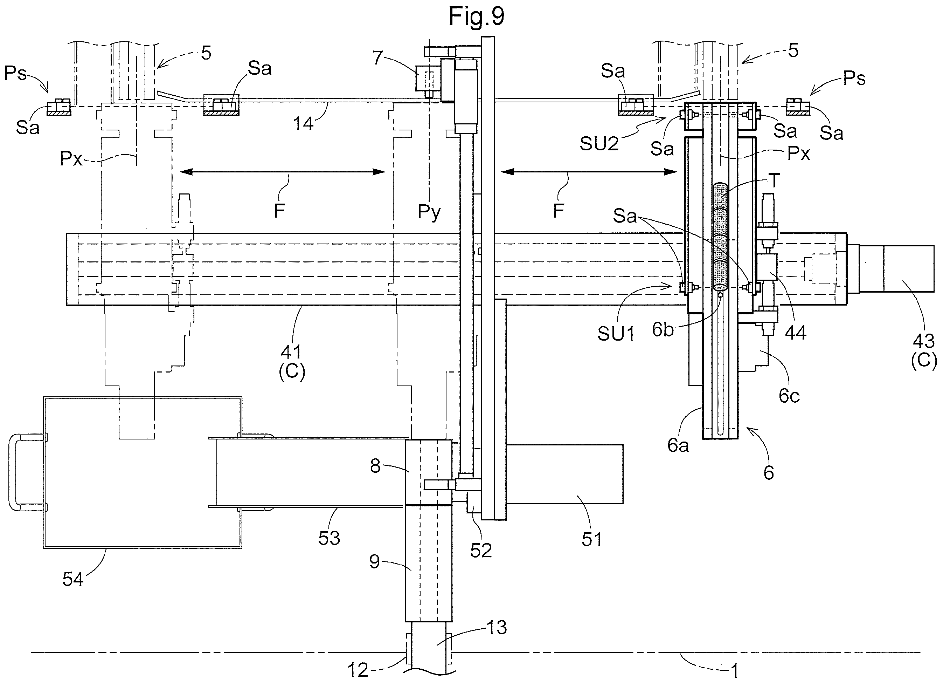

As illustrated in FIG. 9, the shift guide 6 is configured to perform a shifting operation, that is, to reciprocate in a shift direction F orthogonal to the direction in which the feed guides 5 convey tablets T, and an adjustment operation in the direction in which the feed guides 5 convey tablets T (that is, the longitudinal direction of a shift rail 6a). The shift guide 6 includes an operation mechanism C for performing the shifting operation and the adjustment operation. The shift guide 6 includes a linear shift rail 6a having a groove extending along the rail and disposed in the widthwise middle and configured to receive tablets T. The shift rail 6a is movable through the shifting operation between two receiving positions Px at which the shift rail 6a is capable of receiving tablets T from the respective feed guides 5.

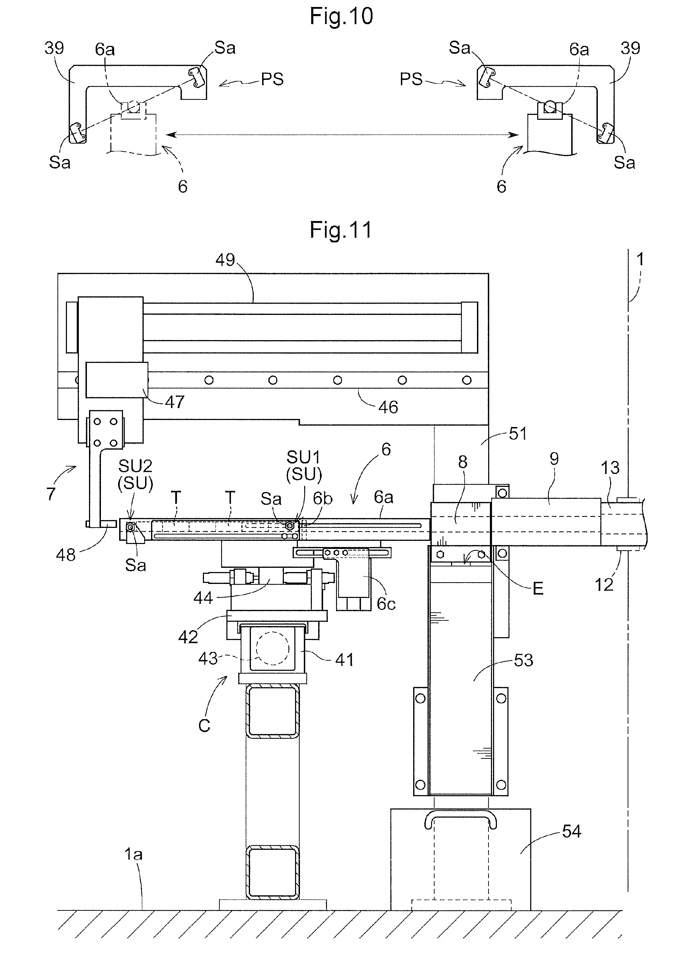

As illustrated in FIGs. 9 and 10, the shift guide 6 includes two position sensors PS disposed near the respective downstream ends of the feed guides 5 and each configured to detect the presence or absence of a tablet T that is bridging the gap between the corresponding feed rail 5a and the shift rail 6a. The shift rail 6a performing the shifting operation with a tablet T bridging the gap between a feed rail 5a and the shift rail 6a may break the tablet T with shearing force. The position sensors PS serve to prevent such an inconvenience. The position sensors PS each include a pair of elements Sa, namely a light-emitting element and a light-receiving element, attached to a support 39.

As illustrated in FIGs. 9 and 11, the operation mechanism C includes a linear guide 41, a slide frame 42. a linear actuator 43, and an adjustment cylinder 44.

The linear guide 41 is disposed at a bottom portion of the case 1 and oriented to have a length in the shift direction F mentioned above. The slide frame 42 is movable along the linear guide 41. The linear actuator 43 is electrically operable to move the slide frame 42 along the linear guide 41. The adjustment cylinder 44 is operable with use of a fluid pressure to move the shift rail 6a in the direction of the adjustment operation. The shift rail 6a is supported by a portion of the operation mechanism C which portion is movable by the adjustment cylinder 44.

The shift rail 6a is movable through the shifting operation described above to any of two receiving positions Px, at which the shift rail 6a receives tablets T from the respective feed guides 5, and a discharge position Py midway between the two receiving positions Px, at which discharge position Py the shift rail 6a discharges tablets T. The shift rail 6a performs the adjustment operation described above to solve the problem of a tablet T bridging the gap between a feed rail 5a and the shift rail 6a. The adjustment operation, similarly to the position sensors PS, serves to prevent a tablet T from being broken with shearing force. If either position sensor PS detects a tablet T bridging the gap between two rails after the adjustment cylinder 44 causes the shift rail 6a to perform the adjustment operation, the control unit 10 handles the error, that is, stops the operation of the tablet stocker A and notifies the operator of the error by, for example, sounding an alarm or causing a monitor to display the error.

The shift guide 6 includes a restrictor 6b disposed downstream in the direction in which the shift guide 6 conveys tablets T and configured to be pushed up from below to restrict the conveyance of tablets T and pulled down to allow the conveyance of tablets T. The shift guide 6 includes a fluid-pressure restriction cylinder 6c configured to push and pull the restrictor 6b and provided for a member movable integrally with the shift rail 6a.

More specifically, the restrictor 6b functions not only to be pushed up to restrict the conveyance of tablets T, but also to cause the shift rail 6a to receive tablets T in an area extending from the position of the tablet T directly stopped by the restrictor 6b to the upstream end of the shift rail 6a so that the shift rail 6a holds a predetermined number of tablets T.

The shift guide 6 further includes a determination sensor unit SU configured to detect that the shift rail 6a has received the predetermined number of tablets T. The determination sensor unit SU includes a first sensor SU1 and a second sensor SU2. The first sensor SU1 is configured to detect that one of the tablets T received by the shift guide 6 which is positioned furthest downstream and directly stopped by the restrictor 6b. The second sensor SU2 is configured to detect that one of the tablets T received by the shift guide 6 which is positioned furthest upstream. In response to the first and second sensors SU1 and SU2 detecting tablets T, the control unit 10 determines that the shift guide 6 is holding the predetermined number of tablets T.

The first and second sensors SU1 and SU2 are each provided for a member movable integrally with the shift rail 6a. The first and second sensors SU1 and SU2 each include a pair of elements Sa, namely a light-emitting element and a light-receiving element, configured to emit and receive a light beam through a hole in the shift rail 6a which hole extends perpendicularly to the longitudinal direction of the shift rail 6a.

With the above configuration, the linear actuator 43 operates to move the shift guide 6 to any of two receiving positions Px and a discharge position Py. The receiving positions Px are each on an imaginary line extending from the corresponding feed guide 5 in its conveyance direction. The discharge position Py is midway between the receiving positions Px, and is where the shift guide 6 discharges tablets T.

More specifically, the shift guide 6 receives a predetermined number of tablets T from one of the feed guides 5 at the corresponding receiving position Px. Then, to solve the problem of a tablet T, if any, bridging the gap between the corresponding feed rail 5a and the shift rail 6a, the control unit 10 causes the adjustment cylinder 44 to operate to increase the gap before causing the shift rail 6a to move to the discharge position Py.

The tablet stocker A includes a fall prevention plate 14 extending in the direction in which the shift guide 6 moves and disposed proximate to the respective downstream ends of the feed rails 5a. The fall prevention plate 14 serves to prevent a tablet T at the upstream end of the shift rail 6a from falling when the shift guide 6 moves from the current receiving position Px to the discharge position Py.

### [End guide as Configuration for Conveying Tablets]

As illustrated in FIGs. 9 and 11, the relay guide 8 and the end guide 9 are at the downstream end of the shift guide 6 at the discharge position Py, and are arranged linearly in the direction of conveying tablets T. The relay guide 8 and the end guide 9 are each in the form of a pipe that allows tablets T to pass through. The discharge port 12 is at the downstream end of the end guide 9.

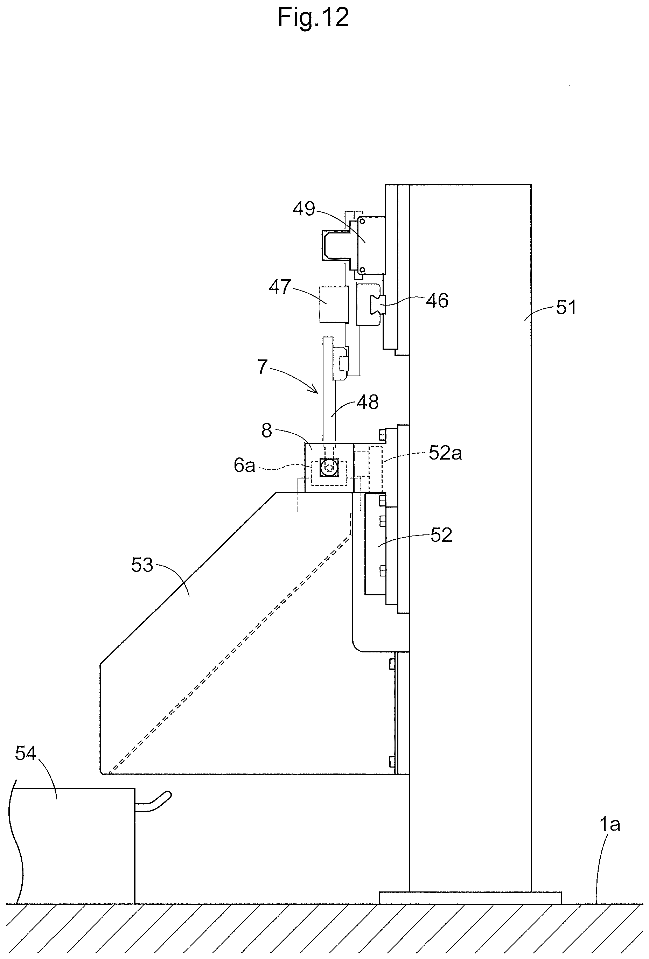

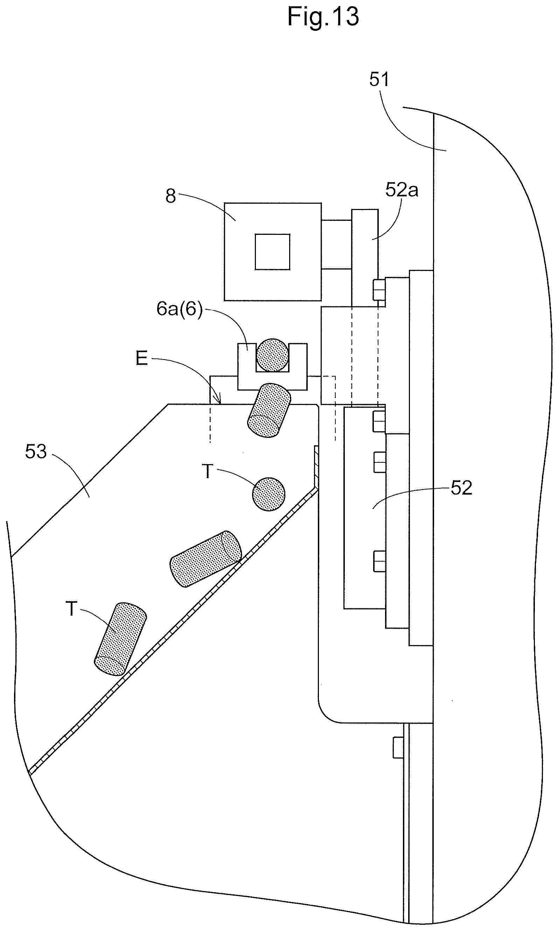

As illustrated in FIGs. 12 and 13, the tablet stocker A includes a vertical frame 51 inside the case 1 and a vertical, fluid-pressure lifting cylinder 52 provided for the vertical frame 51 and including a piston rod 52a holding the relay guide 8.

Pulling the piston rod 52a places the relay guide 8 at a relay position illustrated in FIGs. 11 and 12, at which the relay guide 8 serves as a relay between the shift guide 6 and the end guide 9. With the relay guide 8 at the relay position, the pusher 7 pushing tablets T out of the shift guide 6 causes the tablets T to be supplied through the relay guide 8 to the end guide 9. A later description will deal with how the pusher 7 is configured.

Pushing the piston rod 52a moves the relay guide 8 upward relative to the relay position and places the relay guide 8 at the shifted position illustrated in FIG. 13. With the relay guide 8 at the shifted position, the pusher 7 pushing tablets T out of the shift guide 6 causes the tablets T to fall from the downstream end of the shift guide 6 and not be transferred to the end guide 9.

The relay guide 8 is between the shift guide 6 and the end guide 9. The lifting cylinder 52 operates to place the relay guide 8 at either of the relay position and the shifted position. Moving the relay guide 8 to the shifted position illustrated in FIG. 13 creates a discharge gap E under the space between the shift guide 6 and the end guide 9. This allows the shift guide 6 to discharge tablets T through the discharge gap E.

As illustrated in FIGs. 11 and 12, the tablet stocker A includes a back chute 53 and a back collection case 54 inside the case 1. The back chute 53 is configured to receive tablets T through the discharge gap E and guide the tablets T while the relay guide 8 is at the shifted position. The back collection case 54 is disposed on the bottom wall 1a of the case 1 and configured to collect tablets T from the back chute 53.

As illustrated in FIGs. 9, 11, and 12, the pusher 7 ("moving mechanism") includes a guide rail 46, a slider 47 movable along the guide rail 46, and a contact member 48 movable integrally with the slider 47. The pusher 7 further includes a fluid-pressure pushing cylinder 49 configured to move the slider 47 along the guide rail 46 and held by the vertical frame 51.

The contact member 48 includes a cushion (not illustrated in the drawings) such as a spring or rubber at a portion that comes into contact with a tablet T to apply pressure to the tablet T. Causing the slider 47 to operate to move the contact member 48 carries tablets T held by the shift guide 6 for transfer to the end guide 9 or discharge through the discharge gap E.

### [Outline of How to Convey Tablets]

The control unit 10 is configured to transmit control signals to the belt conveyors 3, the aligner-feeders 4, the respective switching actuators 5c of the downstream stoppers 5b, the operation mechanism C, the restriction cylinder 6c of the restrictor 6b, the pushing cylinder 49 of the pusher 7, and the lifting cylinder 52 for control thereof and receive signals from the respective sensors of the above sections.

The control unit 10 controls any fluid-pressure element for its operation by controlling an electromagnetic valve for controlling the fluid.

The tablet stocker A conveys tablets T from the hoppers 2 to the discharge port 12 for discharge under the following control of the control unit 10: The operation mechanism C places the shift rail 6a at that receiving position Px at which the shift rail 6a will receive tablets T from the corresponding feed guide 5.

The control unit 10 also causes the restrictor 6b of the shift rail 6a to be pushed up and places the downstream stopper 5b of the feed guide 5 at the passage allowing position. The control unit 10 then causes the adjustment cylinder 44 to operate to reduce the gap between the upstream end of the shift guide 6 and the downstream end of the feed guide 5.

The control unit 10 then causes the belt conveyor 3 corresponding to one of the hoppers 2 to start operating and the corresponding aligner-feeder 4 to start operating. This causes the aligner-feeder 4 to feed tablets T from the hopper 2 to the feed rail 5a, which then continuously transfers the tablets T to the shift rail 6a.

In response to the determination sensor unit SU determining that the shift rail 6a has received a predetermined number of tablets T, the control unit 10 places the downstream stopper 5b of the feed rail 5a at the passage preventing position.

Placing the downstream stopper 5b at the passage preventing position prevents the feed rail 5a from continuing to transfer tablets T to the shift rail 6a. Further, in response to the arrival sensor 5S detecting a tablet T, the control unit 10 stops the respective operations of the belt conveyor 3 and the aligner-feeder 4.

The control unit 10 then causes the operation mechanism C to cause the adjustment cylinder 44 to operate to increase the gap between the upstream end of the shift guide 6 and the downstream end of the feed rail 5a and then move the shift rail 6a to the discharge position Py.

After placing the shift rail 6a at the discharge position Py, the control unit 10 causes the restrictor 6b to stop its restriction and the contact member 48 of the pusher 7 to operate. The control unit 10 thereby causes tablets T on the shift rail 6a to sequentially pass through the relay guide 8 at the relay position and the end guide 9 to be discharged through the discharge port 12 and supplied through the conveying path 13 to the resin molding apparatus B under negative pressure.

The aligner-feeders 4 of the tablet stocker A each include a sensor (not illustrated in the drawings) for the tablet stocker A to determine that the aligner-feeder 4 has stopped receiving tablets T from the corresponding belt conveyor 3. In response to the sensor continuing to detect no tablet T over a predetermined time period, the tablet stocker A determines that the upstream hopper 2 has discharged all its tablets T. The tablet stocker A is configured to then optionally cause the other hopper 2 to start discharging its tablets T.

### [Discard Section and Discard Operation]

The tablet stocker A is configured such that the control unit 10 causes tablets T to be discarded for a switch of kinds of tablets T to be supplied to the resin molding apparatus B or for maintenance.

The control unit 10 at least either (i) causes either or both of the rotation cylinders 35 to operate to discard tablets T on the feed rail(s) 5a or (ii) causes the lifting cylinder 52 and the pushing cylinder 49 to operate to discard tablets T on the shift rail 6a.

To discard tablets T on a feed rail 5a, for instance, the control unit 10 rotates the feed rail 5a into the discard state illustrated in FIG. 8. This allows the front collection case 37 to collect the tablets T through the front chutes 36, completing the discard of tablets T from the feed rail 5a.

To discard tablets T on the shift rail 6a, for instance, the control unit 10 places the shift rail 6a at the discharge position Py and moves the relay guide 8 to the shifted position illustrated in FIG. 13 with use of driving force of the lifting cylinder 52. The control unit 10 then causes the pushing cylinder 49 of the pusher 7 to operate to cause the contact member 48 to push tablets T out of the shift rail 6a. This allows the back collection case 54 to collect the tablets T through the back chute 53, completing the discard of tablets T from the shift rail 6a.

When the two hoppers 2 store tablets T of respective different materials, and a first one of the hoppers 2 starts to discharge its tablets T after the second hopper 2, the control unit 10, for instance, sets the tablet stocker A in the selective feed mode to stop the first hopper 2 from discharging tablets T and discharge tablets T from the second hopper 2 through the discharge port 12. If a feed rail 5a or the shift rail 6a is still holding tablets T from the first hopper 2, the control unit 10 causes the tablets T to be discarded as described above.

### [Summary of Above Embodiments]

The description below summarizes the tablet stocker A ("resin supply apparatus"), the resin molding system RS, and the method for producing resin molded products 26 each described above as an embodiment.
(1) A tablet stocker A ("resin supply apparatus") characteristically includes: a plurality of hoppers 2 ("resin storages") each configured to store a plurality of columnar tablets T ("resin material pieces"); a plurality of aligner-feeders 4 ("resin conveying mechanisms") corresponding to the respective hoppers 2 and each configured to receive the tablets T from a corresponding one of the hoppers 2, align the tablets T, and feed the tablets T; a plurality of feed guides 5 corresponding to the respective aligner-feeders 4 and each configured to receive the tablets T from a corresponding one of the aligner-feeders 4 and hold the tablets T as the tablets T are arranged linearly; a shift guide 6 movable between a plurality of receiving positions Px, at which the shift guide 6 receives the tablets T from the respective feed guides 5, and a discharge position Py, at which the shift guide 6 discharges the tablets T that the shift guide 6 has received; and a pusher 7 ("moving mechanism") facing the discharge position Py and configured to move the tablets T that the shift guide 6 has received to a discharge port 12.

With the above configuration, the aligner-feeders 4 each feed tablets T from the corresponding hopper 2 to the corresponding feed guide 5, which then holds the tablets T as the tablets T are aligned. The tablet stocker A places the shift guide 6 at the corresponding receiving position Px so that the shift guide 6 receives the tablets T from the feed guide 5, and then moves the shift guide 6 to the discharge position Py so that the pusher 7 is able to discharge the tablets T, which the shift guide 6 has received, through the discharge port 12.

The tablet stocker A is capable of, after one of the hoppers 2 storing tablets T of the same resin has discharged all its tablets T, causing another hopper 2 to start discharging its tablets T. This allows tablets T to be supplied continuously over a long time period.

(2) The tablet stocker A ("resin supply apparatus") may further include: an operation mechanism C configured to move the shift guide 6 between the receiving positions Px and the discharge position Py; and a control unit 10 configured to control at least the pusher 7 ("moving mechanism") and the operation mechanism C, wherein the control unit 10 is configured to: control the operation mechanism C so that the operation mechanism C moves the shift guide 6 to one of the receiving positions Px to cause the shift guide 6 to receive the tablets T from a corresponding one of the feed guides 5 and subsequently moves the shift guide 6 to the discharge position Py, and control the pusher 7 so that with the shift guide 6 at the discharge position Py, the pusher 7 discharges the tablets T through the discharge port 12.

With the above configuration, the control unit 10 is capable of controlling the operation mechanism C and the pusher 7 as follows: The operation mechanism C places the shift guide 6 at a receiving position Px to receive tablets T from the corresponding feed guide 5, and then moves the shift guide 6 to the discharge position Py. The pusher 7 subsequently discharges the tablets T from the shift guide 6 through the discharge port 12.

(3) The tablet stocker A ("resin supply apparatus") may be further configured such that the feed guides 5 each include a downstream stopper 5b ("stopper") disposed at an end through which the feed guide 5 transfers the tablets T and configured to prevent the transfer of the tablets T, and the downstream stopper 5b is switchable between a passage preventing position, at which the downstream stopper 5b prevents the transfer of the tablets T, and a passage allowing position, at which the downstream stopper 5b allows the transfer of the tablets T.

In placing the shift guide 6 at a receiving position Px to receive tablets T from the corresponding feed guide 5, the tablet stocker A configured as above places the downstream stopper 5b at the passage allowing position to allow the tablets T to be continuously transferred from the feed guide 5 to the shift guide 6. After the feed guide 5 finishes transferring the tablets T as above, the tablet stocker A switches the downstream stopper 5b to the passage preventing position. The downstream stopper 5b thereby prevents tablets T from falling from the transfer-side end of the feed guide 5 after the shift guide 6 has moved to the discharge position Py.

(4) The tablet stocker A ("resin supply apparatus") may be further configured such that the feed guides 5 each include an arrival sensor 5S disposed at an end through which the feed guide 5 transfers the tablets T and configured to detect one of the tablets T.

With the above configuration, the arrival sensor 5S is capable of detecting that a tablet T received from the corresponding aligner-feeder 4 has arrived at the end of the feed guide 5 which end is downstream in the direction in which the feed guide 5 conveys tablets T. The tablet stocker A is also capable of determining in response to the arrival sensor 5S detecting no tablet T that the hopper 2 in operation has discharged all its tablets T.

(5) The tablet stocker A ("resin supply apparatus") may further include: a determination sensor unit SU configured to determine whether the shift guide 6 has received a predetermined number of the tablets T.

With the above configuration, the tablet stocker A is capable of, in response to the determination sensor unit SU determining that the shift guide 6 has received the predetermined number of tablets T, moving the shift guide 6 to the discharge position Py and discharging the tablets T through the discharge port 12.

(6) The tablet stocker A ("resin supply apparatus") may further include: a plurality of rotation cylinders 35 ("actuators") corresponding to the respective feed guides 5 and each configured to change a state of a corresponding one of the feed guides 5, the rotation cylinders 35 are each configured to change the state of the corresponding feed guide 5 between (i) a state in which the corresponding feed guide 5 linearly arranges the tablets T thereon and (ii) a state in which the corresponding feed guide 5 allows the tablets T thereon to fall therefrom.

In discarding tablets T from a feed guide 5, the tablet stocker A configured as above is capable of causing the corresponding rotation cylinder 35 to operate to rotate the feed guide 5 so that tablets T fall from the feed guide 5.

(7) The tablet stocker A ("resin supply apparatus") may further include: an end guide 9 configured to receive the tablets T transferred from the shift guide 6 at the discharge position Py through operation of the pusher 7; and a relay guide 8 disposed between the shift guide 6 and the end guide 9 and configured to transfer the tablets T from the shift guide 6 to the end guide 9, wherein the relay guide 8 is movable between a relay position, at which the relay guide 8 transfers the tablets T from the shift guide 6 to the end guide 9, and a shifted position, at which the relay guide 8 lets the tablets T fall from an end of the shift guide 6 through which end the shift guide 6 transfers the tablets T.

In discarding tablets T from the shift guide 6, the tablet stocker A configured as above is capable of moving the relay guide 8 to the shifted position and causing the pusher 7 to operate to discharge tablets T from the downstream end of the shift guide 6 and not transfer the tablets T to the end guide 9. The tablet stocker A configured as above uses the pusher 7 to discharge tablets T from the shift guide 6. This eliminates the need for a dedicated actuator for discarding tablets T, thereby preventing an additional member from being included.

(8) A resin molding system RS characteristically includes: the tablet stocker A ("resin supply apparatus"); and a resin molding apparatus B configured for resin molding with use of the tablets T from the tablet stocker A.

The above configuration allows the resin molding apparatus B to perform resin molding with use of tablets T from the tablet stocker A.

(9) The resin molding system RS may further include: a conveying path 13 configured to convey the tablets T from the tablet stocker A to the resin molding apparatus B.

The above configuration allows tablets T to be supplied from the tablet stocker A through the conveying path 13 to the resin molding apparatus B. This, in particular, allows the resin molding apparatus B in, for instance, a clean room to receive tablets T from the tablet stocker A outside the clean room through the conveying path 13.

(10) A method for producing a resin molded product 26, the method characteristically including: supplying the tablets T from a tablet stocker A; and resin molding with use of the tablets T supplied from the tablet stocker A.

The above configuration allows tablets T from the supplying step to be used for molding during the resin molding step.

### [Effects of Embodiments]

With the above configuration, the control unit 10, for instance, sets the tablet stocker A in the continuous feed mode to supply tablets T from one of the hoppers 2 to the resin molding apparatus B and in response to the hopper 2 having discharged all its tablets T, supply tablets T from the other hopper 2 to the resin molding apparatus B. The tablet stocker A ("resin supply apparatus") is thereby capable of storing more tablets T and supplying tablets T over a longer time period than a tablet stocker including only one hopper.

The tablet stocker A may alternatively include three or more sets of hoppers 2, belt conveyors 3, aligner-feeders 4, and feed guides 5 to be capable of supplying tablets T over an even longer time period.

The tablet stocker A ("resin supply apparatus") may be in the selective feed mode under control of the control unit 10 with the two hoppers 2 storing tablets T of respective different resin materials. This allows the tablet stocker A to, at any time point while discharging tablets T from one hopper 2 through the discharge port 12, start discharging tablets T from the other hopper 2 through the discharge port 12.

For such an operation in the selective feed mode, the tablet stocker A is capable of (i) causing the rotation cylinder 35 in current use to operate to discard tablets T on the corresponding feed guide 5 and also (ii) causing the lifting cylinder 52 and the pushing cylinder 49 to operate to discard tablets T on the shift guide 6 before a switch of kinds of tablets T. This eliminates the need for an operator to perform any particular task.

When the tablet stocker A places the shift guide 6 at a receiving position Px to receive tablets T from the corresponding feed guide 5, the tablet stocker A causes the restrictor 6b of the shift guide 6 to be pushed up. The shift guide 6 receives a predetermined number of tablets T as the first and second sensors SU1 and SU2 each detect a tablet T.

After the shift guide 6 has received a predetermined number of tablets T as above, the tablet stocker A moves the shift guide 6 to the discharge position Py with the gap between the feed guide 5 and the shift guide 6 increased. The tablet stocker A then causes the pushing cylinder 49 to operate to move the tablets T from the shift guide 6 through the relay guide 8 and the end guide 9 to the discharge port 12 and discharge the tablets T into the conveying path 13.

When the tablet stocker A moves the shift guide 6 from a receiving position Px to the discharge position Py, the tablet stocker A places the downstream stopper 5b of the corresponding feed guide 5 at the passage preventing position and detects a tablet T with use of the arrival sensor 5S. The tablet stocker A then stops the corresponding belt conveyor 3 and aligner-feeder 4. This prevents the conveyance path from being overflowed with tablets T.

### [Alternative Embodiments]

This disclosure may alternatively be configured as below other than as described for the above embodiments. Elements of the embodiments below that are identical in function to elements described for the above embodiments are assigned identical reference signs.
(a) As partly described under [Effects of Embodiments], the tablet stocker A ("resin supply apparatus") may include three or more sets of hoppers 2 ("resin storages"), belt conveyors 3, aligner-feeders 4 ("resin conveying mechanisms"), and feed guides 5. This configuration allows the tablet stocker A to not only store more tablets T, but also store tablets T of three or more different resin materials in the hoppers 2 and switch resin materials as necessary, thereby allowing selection from multiple resin materials.
(b) The tablet stocker A ("resin supply apparatus") may be configured such that at least either the feed rails 5a or the shift rail 6a is inclined with the downstream end(s) slightly lowered. This allows tablets T to be conveyed smoothly. The feed guides 5 may alternatively be each in the form of a belt conveyor or roller conveyor configured to convey tablets T with driving force. This allows the feed guides 5 to reliably convey tablets T.
(c) The shifted position for the relay guide 8 may alternatively be, for example, lateral to or obliquely upward or downward of the relay position. Further, the relay guide 8 is movable to the shifted position not necessarily with use of a linearly operable element such as a cylinder. The relay guide 8 may, for instance, be provided with an arm extending outward therefrom and a shaft or the like holding the distal end of the arm in such a manner that the arm is swingable. Swinging the relay guide 8 integrally with the arm moves the relay guide 8 to the shifted position.
(d) The resin molding system RS may have two or more discharge ports 12 and two or more conveying paths 13 for supplying tablets T from the respective discharge ports 12 to two or more resin molding apparatuses B. The resin molding system RS is, in this case, configured to move the shift guide 6 to either of the discharge ports 12 (that is, either of the discharge positions Py) and discharge tablets T through the discharge port 12.

Alternative embodiment (d) is a single tablet stocker A configured to supply tablets T to two or more resin molding apparatuses B. The tablet stocker A configured as such may include two or more pushers 7 ("moving mechanism"), relay guides 8, and end guides 9 in correspondence with the respective discharge ports 12 similarly to the embodiments described under [Description of Embodiments].

The arrangements disclosed for the above embodiments (including the alternative embodiments; hereinafter the same applies) may each be combined with an arrangement disclosed for another embodiment, as long as such a combination does not cause a contradiction. Further, the embodiments disclosed in the present specification are mere examples. This disclosure is not limited to those embodiments, and may be altered as appropriate, as long as such an alteration does not result in a failure to attain an object of this disclosure.

### Industrial Applicability

This disclosure is applicable to a resin supply apparatus, a resin molding system, and a method for producing a resin molded product.

### Reference Signs List

- 2: Hopper (resin storage)
- 4: Aligner-feeder (resin conveying mechanism)
- 5: Feed guide
- 5b: Downstream stopper (stopper)
- 5S: Arrival sensor
- 6: Shift guide
- 7: Pusher (moving mechanism)
- 8: Relay guide
- 9: End guide
- 10: Control unit
- 12: Discharge port
- 13: Conveying path
- 35: Rotation cylinder (actuator)
- A: Tablet stocker (resin supply apparatus)
- B: Resin molding apparatus
- C: Operation mechanism
- E: Discharge gap
- Px: Receiving position
- Py: Discharge position
- RS: Resin molding system
- SU: Determination sensor unit
- T: Tablet (resin material piece)
- X: Rotation axis

## Claims

1. A resin supply apparatus (A), comprising:
a plurality of resin storages (2) each configured to store a plurality of columnar resin material pieces (T);
a plurality of resin conveying mechanisms (4) corresponding to the respective resin storages (2) and each configured to receive the resin material pieces (T) from a corresponding one of the resin storages (2), align the resin material pieces (T), and feed the resin material pieces;
a plurality of feed guides (5) corresponding to the respective resin conveying mechanisms (4) and each configured to receive the resin material pieces (T) from a corresponding one of the resin conveying mechanisms (4) and hold the resin material pieces (T) as the resin material pieces are arranged linearly; **characterized by**
a shift guide (6) movable between a plurality of receiving positions (Px), at which the shift guide (6) receives the resin material pieces (T) from the respective feed guides (5), and a discharge position (Py), at which the shift guide (6) discharges the resin material pieces (T) that the shift guide (6) has received; and
a moving mechanism (7) facing the discharge position (Py) and configured to move the resin material pieces (T) that the shift guide (6) has received to a discharge port (12).

2. The resin supply apparatus (A) according to claim 1, further comprising:
an operation mechanism (C) configured to move the shift guide (6) between the receiving positions (Px) and the discharge position (Py); and
a control unit (10) configured to control at least the moving mechanism (7) and the operation mechanism (C),
wherein the control unit (10) is configured to:
control the operation mechanism (C) so that the operation mechanism moves the shift guide (6) to one of the receiving positions (Px) to cause the shift guide (6) to receive the resin material pieces (T) from a corresponding one of the feed guides and subsequently moves the shift guide (6) to the discharge position (Py), and
control the moving mechanism (7) so that with the shift guide (6) at the discharge position (Py), the moving mechanism (7) discharges the resin material pieces (T) through the discharge port (12).

3. The resin supply apparatus (A) according to claim 1 or 2, wherein
the feed guides (5) each include a stopper (5b) disposed at an end through which the feed guide (5) transfers the resin material pieces (T) and configured to prevent the transfer of the resin material pieces, and
the stopper (5b) is switchable between a passage preventing position, at which the stopper prevents the transfer of the resin material pieces, and a passage allowing position, at which the stopper allows the transfer of the resin material pieces.

4. The resin supply apparatus (A) according to any one of claims 1 to 3, wherein
the feed guides (5) each include an arrival sensor (5S) disposed at an end through which the feed guide (5) transfers the resin material pieces (T) and configured to detect one of the resin material pieces.

5. The resin supply apparatus (A) according to any one of claims 1 to 4, further comprising:
a determination sensor unit (SU) configured to determine whether the shift guide (6) has received a predetermined number of the resin material pieces (T).

6. The resin supply apparatus (A) according to any one of claims 1 to 5, further comprising:
a plurality of actuators (35) corresponding to the respective feed guides (5) and each configured to change a state of a corresponding one of the feed guides (6),
the actuators (35) are each configured to change the state of the corresponding feed guide (5) between (i) a state in which the corresponding feed guide (5) linearly arranges the resin material pieces (T) thereon and (ii) a state in which the corresponding feed guide (5) allows the resin material pieces (T) thereon to fall therefrom.

7. The resin supply apparatus (A) according to any one of claims 1 to 6, further comprising:
an end guide (9) configured to receive the resin material pieces (T) transferred from the shift guide (6) at the discharge position (Py) through operation of the moving mechanism (7); and
a relay guide (8) disposed between the shift guide (6) and the end guide (9) and configured to transfer the resin material pieces (T) from the shift guide (6) to the end guide (9),
wherein the relay guide (8) is movable between a relay position, at which the relay guide (8) transfers the resin material pieces (T) from the shift guide (6) to the end guide (9), and a shifted position, at which the relay guide (8) lets the resin material pieces (T) fall from an end of the shift guide (6) through which end the shift guide (6) transfers the resin material pieces (T).

8. A resin molding system (RS), comprising:
a resin supply apparatus (A) according to any one of claims 1 to 7; and
a resin molding apparatus (B) configured for resin molding with use of the resin material pieces (T) from the resin supply apparatus (A).

9. The resin molding system (RS) according to claim 8, further comprising:
a conveying path (13) configured to convey the resin material pieces (T) from the resin supply apparatus (A) to the resin molding apparatus (B).

10. A method for producing a resin molded product,
the method comprising:
supplying the resin material pieces (T) from a resin supply apparatus (A) according to any one of claims 1 to 7; and
resin molding with use of the resin material pieces (T) supplied from the resin supply apparatus (A).

## Patentansprüche

1. Harzzuführvorrichtung (A) mit:
einer Vielzahl von Harzspeichern (2), die jeweils konfiguriert sind, um eine Vielzahl von säulenförmigen Harzmaterialstücken (T) zu speichern;
einer Vielzahl von Harztransportmechanismen (4), die den jeweiligen Harzspeichern (2) entsprechen und jeweils konfiguriert sind, um die Harzmaterialstücke (T) von einem entsprechenden Harzspeicher (2) zu empfangen, die Harzmaterialstücke (T) auszurichten und die Harzmaterialstücke zuzuführen; und
einer Vielzahl von Zuführführungen (5), die den jeweiligen Harztransportmechanismen (4) entsprechen und jeweils konfiguriert sind, um die Harzmaterialstücke (T) von einem der entsprechenden Harztransportmechanismen (4) zu empfangen und die Harzmaterialstücke (T) linear angeordnet zu halten;
**gekennzeichnet durch**
eine Bewegungsführung (6), die zwischen einer Vielzahl von Empfangspositionen (Px), an denen die Bewegungsführung (6) die Harzmaterialstücke (T) von den jeweiligen Zuführführungen (5) empfängt, und einer Abgabeposition (Py), an der die Bewegungsführung (6) die von ihr empfangenen Harzmaterialstücke (T) abgibt, bewegbar ist; und
einen Bewegungsmechanismus (7), der der Abgabeposition (Py) zugewandt ist und konfiguriert ist, um die von der Bewegungsführung (6) empfangenen Harzmaterialstücke (T) zu einer Abgabeöffnung (12) zu bewegen.

2. Harzzuführvorrichtung (A) nach Anspruch 1, ferner mit:
einem Betätigungsmechanismus (C), der konfiguriert ist, um die Bewegungsführung (6) zwischen den Empfangspositionen (Px) und der Abgabeposition (Py) zu bewegen; und
einer Steuereinheit (10), die konfiguriert ist, um mindestens den Bewegungsmechanismus (7) und den Betätigungsmechanismus (C) zu steuern,
wobei die Steuereinheit (10) konfiguriert ist, um:
den Betätigungsmechanismus (C) so zu steuern, dass er die Bewegungsführung (6) zu einer der Empfangspositionen (Px) bewegt, so dass die Bewegungsführung (6) die Harzstücke (T) von einer der entsprechenden Zuführführungen (5) empfängt und dann die Bewegungsführung (6) zu der Abgabeposition (Py) bewegt, und
den Bewegungsmechanismus (7) so zu steuern, dass, wenn sich die Bewegungsführung (6) in der Abgabeposition (Py) befindet, der Bewegungsmechanismus (7) die Harzmaterialstücke (T) durch die Abgabeöffnung (12) abgibt.

3. Harzzuführvorrichtung (A) nach Anspruch 1 oder 2, wobei
die Zuführführungen (5) jeweils einen Anschlag (5b) umfassen, der an einem Ende angeordnet ist, durch das die Zuführführung (5) die Harzmaterialstücke (T) überträgt, und konfiguriert ist, um die Übertragung der Harzmaterialstücke zu verhindern, und
der Anschlag (5b) von einer Durchgangsverhinderungsposition, in der der Anschlag die Übertragung der Harzmaterialstücke verhindert, zu einer Durchgangszulassungsposition, in der der Anschlag die Übertragung der Harzmaterialstücke zulässt, bewegbar ist.

4. Harzzuführvorrichtung (A) nach einem der Ansprüche 1 bis 3, wobei die Zuführführungen (5) jeweils einen Ankunftssensor (5S) umfassen, der an einem Ende angeordnet ist, durch das die Zuführführung (5) die Harzmaterialstücke (T) überträgt, und konfiguriert ist, um eines der Harzmaterialstücke zu erfassen.

5. Harzzuführvorrichtung (A) nach einem der Ansprüche 1 bis 4, ferner mit einer Bestimmungssensoreinheit (SU), die konfiguriert ist, um zu bestimmen, ob die Geschwindigkeitsänderungsführung (6) eine vorbestimmte Anzahl von Harzmaterialstücken (T) empfangen hat.

6. Harzzuführvorrichtung (A) nach einem der Ansprüche 1 bis 5, ferner mit einer Vielzahl von Stellgliedern (35), die den jeweiligen Zuführführungen (5) entsprechen und jeweils konfiguriert sind, um den Zustand einer der entsprechenden Zuführführungen (6) zu ändern, wobei
die Stellglieder (35) jeweils konfiguriert sind, um den Zustand der entsprechenden Zuführführung (5) zwischen (i) einem Zustand, in dem die entsprechende Zuführführung (5) die Harzmaterialstücke (T) linear darauf anordnet, und (ii) einem Zustand, in dem die entsprechende Zuführführung (5) es den darauf angeordneten Harzmaterialstücken (T) erlaubt, dass sie davon abfallen.

7. Harzzuführvorrichtung (A) nach einem der Ansprüche 1 bis 6, ferner mit:
einer Endführung (9), die konfiguriert ist, um die von der Bewegungsführung (6) zu der Abgabeposition (Py) durch die Betätigung des Bewegungsmechanismus (7) übertragenen Harzmaterialstücke (T) zu empfangen; und
einer Relaisführung (8), die zwischen der Bewegungsführung (6) und der Endführung (9) angeordnet ist und konfiguriert ist, um die Harzmaterialstücke (T) von der Bewegungsführung (6) zu der Endführung (9) zu übertragen,
wobei die Relaisführung (8) zwischen einer Relaisposition, in der die Relaisführung (8) die Harzmaterialstücke (T) von der Bewegungsführung (6) zu der Endführung (9) überträgt, und einer versetzten Position, in der die Relaisführung (8) die Harzmaterialstücke (T) von einem Ende der Bewegungsführung (6), durch das die Bewegungsführung (6) die Harzmaterialstücke (T) überträgt, abfallen lässt, bewegbar ist.

8. Harzformsystem (RS) mit:
einer Harzzuführvorrichtung (A) nach einem der Ansprüche 1 bis 7; und
einer Harzformvorrichtung (B), die zum Harzformen unter Verwendung der Harzmaterialstücke (T) von der Harzzuführvorrichtung (A) konfiguriert ist.

9. Harzformsystem (RS) nach Anspruch 8, ferner mit einem Förderweg (13), der konfiguriert ist, um die Harzmaterialstücke (T) von der Harzzuführvorrichtung (A) zu der Harzformvorrichtung (B) zu befördern.

10. Verfahren zum Herstellen eines harzgeformten Produkts, wobei das Verfahren umfasst:
Zuführen von Harzmaterialstücken (T) von einer Harzzuführvorrichtung (A) nach einem der Ansprüche 1 bis 7; und
Harzformen unter Verwendung der Harzmaterialstücke (T), die von der Harzzuführvorrichtung (A) zugeführt werden.

## Revendications

1. Appareil d'alimentation en résine (A), comprenant :
une pluralité de stockages de résine (2), chacun étant configuré pour stocker une pluralité de morceaux de matériau de résine colonnaire (T) ;
une pluralité de mécanismes de transport de résine (4) correspondant aux stockages de résine respectifs (2) et chacun étant configuré pour recevoir les morceaux de matériau de résine (T) d'un stockage de résine correspondant (2), aligner les morceaux de matériau de résine (T) et alimenter les morceaux de matériau de résine ;
une pluralité de guides d'alimentation (5) correspondant aux mécanismes de transport de résine respectifs (4) et chacun étant configuré pour recevoir les morceaux de matériau de résine (T) provenant d'un des mécanismes de transport de résine (4) correspondants et pour maintenir les morceaux de matériau de résine (T) disposés linéairement ; **caractérisé par**
un guide de déplacement (6) mobile entre une pluralité de positions de réception (Px), où le guide de déplacement (6) reçoit les morceaux de matériau de résine (T) provenant des guides d'alimentation respectifs (5), et une position de décharge (Py), où le guide de déplacement (6) décharge les morceaux de matériau de résine (T) qu'il a reçus; et
un mécanisme mobile (7) faisant face à la position de décharge (Py) et configuré pour déplacer les morceaux de matériau de résine (T) que le guide de déplacement (6) a reçus vers un orifice de décharge (12).

2. Appareil d'alimentation en résine (A) selon la revendication 1, comprenant en outre :
un mécanisme de fonctionnement (C) configuré pour déplacer le guide de déplacement (6) entre les positions de réception (Px) et la position de décharge (Py) ; et
une unité de commande (10) configurée pour commander au moins le mécanisme mobile (7) et le mécanisme de fonctionnement (C),
dans lequel l'unité de commande (10) est configurée pour :
commander le mécanisme de fonctionnement (C) de sorte que celui-ci déplace le guide de déplacement (6) vers l'une des positions de réception (Px) afin que le guide de déplacement (6) reçoive les morceaux de résine (T) provenant de l'un des guides d'alimentation (5) correspondants, puis déplace le guide de déplacement (6) vers la position de décharge (Py), et
commander le mécanisme mobile (7) de sorte qu'avec le guide de déplacement (6) en position de décharge (Py), le mécanisme mobile (7) décharge les morceaux de matériau de résine (T) par l'orifice de décharge (12).

3. Appareil d'alimentation en résine (A) selon la revendication 1 ou 2, dans lequel
les guides d'alimentation (5) incluent chacun une butée (5b) disposée à une extrémité par laquelle le guide d'alimentation (5) transfère les morceaux de matériau de résine (T) et configurée pour empêcher le transfert des morceaux de matériau de résine, et
la butée (5b) peut passer d'une position empêchant le passage, dans laquelle la butée empêche le transfert des morceaux de matériau en résine, à une position permettant le passage, dans laquelle la butée permet le transfert des morceaux de matériau en résine.

4. Appareil d'alimentation en résine (A) selon l'une quelconque des revendications 1 à 3, dans lequel
les guides d'alimentation (5) incluent chacun un capteur d'arrivée (5S) disposé à une extrémité par laquelle le guide d'alimentation (5) transfère les morceaux de matériau en résine (T) et configuré pour détecter l'un des morceaux de matériau en résine.

5. Appareil d'alimentation en résine (A) selon l'une quelconque des revendications 1 à 4, comprenant en outre :
une unité de capteur de détermination (SU) configurée pour déterminer si le guide de changement de vitesse (6) a reçu un nombre prédéterminé de pièces de matériau en résine (T).

6. Appareil d'alimentation en résine (A) selon l'une quelconque des revendications 1 à 5, comprenant en outre :
une pluralité d'actionneurs (35) correspondant aux guides d'alimentation respectifs (5) et chacun étant configuré pour changer l'état d'un des guides d'alimentation correspondants (6),
les actionneurs (35) sont chacun configurés pour changer l'état du guide d'alimentation correspondant (5) entre (i) un état dans lequel le guide d'alimentation correspondant (5) dispose linéairement les morceaux de matériau de résine (T) dessus et (ii) un état dans lequel le guide d'alimentation correspondant (5) permet aux morceaux de matériau de résine (T) placés dessus de tomber.

7. Appareil d'alimentation en résine (A) selon l'une quelconque des revendications 1 à 6, comprenant en outre :
un guide d'extrémité (9) configuré pour recevoir les morceaux de matériau de résine (T) transférés du guide de déplacement (6) à la position de décharge (Py) par le fonctionnement du mécanisme mobile (7) ; et
un guide relais (8) disposé entre le guide de déplacement (6) et le guide d'extrémité (9) et configuré pour transférer les morceaux de matériau de résine (T) du guide de déplacement (6) au guide d'extrémité (9),
dans lequel le guide de relais (8) est mobile entre une position de relais, dans lequel le guide de relais (8) transfère les morceaux de matériau résine (T) du guide de déplacement (6) au guide d'extrémité (9), et une position décalée, dans laquelle le guide de relais (8) laisse tomber les morceaux de matériau de résine (T) d'une extrémité du guide de déplacement (6) par laquelle le guide de déplacement (6) transfère les morceaux de matériau résine (T).

8. Système de moulage en résine (RS), comprenant:
un appareil d'alimentation en résine (A) selon l'une quelconque des revendications 1 à 7 ; et
un appareil de moulage de résine (B) configuré pour le moulage de résine à l'aide des pièces de matériau de résine (T) provenant de l'appareil d'alimentation en résine (A).

9. Système de moulage de résine (RS) selon la revendication 8, comprenant en outre :
un chemin de convoyage (13) configuré pour acheminer les morceaux de matériau de résine (T) de l'appareil d'alimentation en résine (A) à l'appareil de moulage de résine (B).

10. Procédé de fabrication d'un produit moulé en résine, le procédé comprenant :
l'approvisionnement en pièces de matériau résineux (T) à partir d'un appareil d'alimentation en résine (A) selon l'une quelconque des revendications 1 à 7 ; et
le moulage de résine à l'aide des pièces de matériau résine (T) fournies par l'appareil d'alimentation en résine (A).
